# EUROPÄISCHE PATENTSCHRIFT

(11) **EP 1 960 119 B1**
(45) Veröffentlichungstag und Bekanntmachung des Hinweises auf die Patenterteilung: **12.05.2010**
(21) Anmeldenummer: 06840992.9
(22) Anmeldetag: 15.12.2006
(51) Int. Cl.: B05C 1/02, B05C 1/08, B05C 1/10, H05K 3/00, B05C 1/16, B05C 13/02

(54) **VORRICHTUNG, ANLAGE UND VERFAHREN ZUR OBERFLÄCHENBEHANDLUNG VON SUBSTRATEN**
DEVICE, SYSTEM AND METHOD FOR TREATING THE SURFACES OF SUBSTRATES
DISPOSITIF, INSTALLATION ET PROCEDE DE TRAITEMENT DE SURFACE DE SUBSTRATS

(30) Priorität: 16.12.2005 DE 102005062528
(43) Veröffentlichungstag der Anmeldung: 27.08.2008
(73) Patentinhaber: Gebr. Schmid GmbH + Co., 72250 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2006/012116
(87) Internationale Veröffentlichungsnummer: WO 2007/073886

(56) Entgegenhaltungen:
- AU-A- 3 687 671
- DE-A1- 2 004 706
- GB-A- 1 269 510
- US-A1- 3 826 228
- US-A1- 4 562 099

## Beschreibung

### Anwendungsgebiet und Stand der Technik

Die Erfindung betrifft eine Vorrichtung sowie eine Anlage mit solchen Vorrichtungen zur Oberflächenbehandlung von Substraten, mit Transportmitteln zum Transport eines Substrats in einer von den Transportmitteln bestimmten Transportebene und mit zumindest einem Fördermittel, das für eine Benetzung des Substrats mit einem flüssigen Prozessmedium ausgebildet ist. Ebenso betrifft die Erfindung ein Verfahren zur Benetzung einer nach unten gewandten Substratoberfläche mit einem Prozessmedium, vorteilhaft in direktem bzw. mechanischem Kontakt.

Aus der DE 102 25 848 A1 sind eine Vorrichtung und ein Verfahren bekannt, die für die Entfernung einer Schicht von einer Oberseite eines flächigen Substrats eingesetzt werden. Dabei wird ein Lösemittel mit Düsen schräg von oben auf die Substrate gespritzt. Die Substrate liegen auf Transportwellen und werden von diesen transportiert. Die Substrate stehen zumindest mit einem seitlichen Ende über die Transportwellen hinaus, so dass vom Substrat abfließendes Lösemittel, das abgelöste Schichtbestandteile enthält, durch den Überstand der Substrate an den Transportmitteln vorbeiströmt. Dadurch soll eine Verunreinigung der Transportmittel verhindert werden. Der Schichtabtrag mit dem Lösemittel dient zur Entfernung von photoaktiven Schichten vor einem Ätzvorgang, um sicherzustellen, dass nur belichtete und entwickelte Oberflächenbereiche des Substrats mit einer für den Ätzvorgang wirksamen Schutzschicht versehen sind. Eine Strukturierung der Schichten ist also bereits durch die Belichtung und Entwicklung der photoaktiven Schichten vorgenommen worden.

Aus der US 4,562,099 ist eine Vorrichtung gemäß dem Oberbegriff des Anspruchs 1 bekannt.

Bei anderen Prozessen zur Oberflächenbehandlung, insbesondere zum Schichtabtrag, die an Substraten, beispielsweise an Siliziumscheiben oder -platten, die als Wafer bezeichnet und insbesondere für die Produktion von Halbleiterbauelementen und Solarzellen eingesetzt werden, vorgenommen werden, kann eine Benetzung von einzelnen Oberflächen des Substrats mit Prozessmedium vorgesehen sein. Die Benetzung soll so erfolgen, dass die übrigen Substratoberflächen, die keine Schutzschicht in der oben genannten Art oder eine andere Beschichtung aufweisen, nicht von dem aufzubringenden Prozessmedium angegriffen werden, so dass ein Schichtabtrag nur an der mit Prozessmedium benetzten Substratoberfläche stattfindet. Dies ist mit der bekannten Vorrichtung nicht gewährleistet.

### Aufgabe und Lösung

Der Erfindung liegt die Aufgabe zugrunde, eine Vorrichtung, eine Anlage sowie ein Verfahren zu schaffen, die eine selektive Oberflächenbehandlung von Substraten ermöglichen.

Diese Aufgabe wird gemäß einem ersten Aspekt der Erfindung durch eine Vorrichtung mit den Merkmalen des Anspruchs 1 gelöst. Vorteilhafte sowie bevorzugte Ausgestaltungen der Erfindung sind Gegenstand der weiteren Ansprüche und werden im folgenden näher erläutert. Die Vorrichtung, die Anlage und das Verfahren werden teilweise gemeinsam erläutert, wobei diese Erläuterungen sowie die entsprechenden Merkmale dennoch unabhängig für Vorrichtung und Verfahren gelten. Der Wortlaut der Ansprüche wird durch die ausdrückliche Bezugnahme zum Inhalt der Beschreibung gemacht.

Die nach unten gewandte Substratoberfläche ist im Wesentlichen eben und ist derart ausgerichtet, dass eine Flächennormale auf diese Substratoberfläche zumindest im Wesentlichen lotrecht in vertikaler Richtung nach unten verläuft. Die nach unten gewandte Substratoberfläche ist in der von den Transportmitteln bestimmten Transportebene angeordnet und stellt die mit Prozessmedium zu benetzende Oberfläche dar. Weitere nach unten gewandte Substratoberflächen, die nicht in der Transportebene liegen, sollen hingegen nicht mit Prozessmedium benetzt werden.

Die Transportebene stellt diejenige Ebene dar, in der ein zu transportierendes Substrat die Transportmittel berührt und ist im Wesentlichen horizontal ausgerichtet oder nimmt einen spitzen Winkel mit einer Horizontalen ein. Je nach Anordnung der Transportmittel kann die Transportebene als gekrümmte Transportfläche ausgeführt sein, wobei eine zumindest im Wesentlichen horizontale Ausrichtung von Transportflächenabschnitten vorgesehen ist.

Um eine selektive Benetzung der nach unten gewandten Substratoberfläche mit dem Prozessmedium zu gewährleisten, ist ein direkter Kontakt zwischen der Fördereinrichtung und der nach unten gewandten Substratoberfläche vorgesehen. Dadurch kann ein Flüssigkeitsfilm des Prozessmediums, der an einer Außenoberfläche der Fördereinrichtung anhaftet, auf die zu benetzende, nach unten weisende Substratoberfläche übertragen werden, ohne dass dabei eine unerwünschte und unkontrollierbare Verbreitung von flüssigem, gasförmigem oder sprühnebelartigem Prozessmedium auftritt. Vielmehr wird der Flüssigkeitsfilm auf der Substratoberfläche abgewälzt oder abgestreift, so dass nur eine sehr geringe Verbreitung des Prozessmediums stattfindet. Dadurch wird erreicht, dass Substratoberflächen, auf denen keine Benetzung vorgesehen ist, nicht in unerwünschter Weise mit Prozessmedium beaufschlagt werden. Dies gewährleistet eine hohe Selektivität des Benetzungsvorgangs und des durch das Prozessmedium hervorgerufenen Bearbeitungsvorgangs.

In Ausgestaltung der Erfindung ist vorgesehen, dass dem Fördermittel eine Zuführeinrichtung für die Zuführung von Prozessmedium auf eine Außenoberfläche des Fördermittels zugeordnet ist. Eine Zuführeinrichtung kann als Sprühdüse ausgeführt sein, die beispielsweise durch eine Sprühblende einen Bereich der Außenoberfläche des Fördermittels besprüht, der durch eine Bewegung des Fördermittels in mechanischen Kontakt mit der Substratoberfläche gebracht werden kann. Bei einer bevorzugten Ausführungsform der Erfindung ist die Zuführeinrichtung als Becken zur Aufnahme des flüssigen Prozessmediums gestaltet und das Fördermittel kann zeitweise, bevorzugt kontinuierlich, insbesondere bereichsweise unterhalb eines Flüssigkeitsspiegels des Prozessmediums bewegt werden, so dass Prozessmedium auf die Außenoberfläche des Fördermittels übertragen werden kann, von der aus eine Übertragung auf die nach unten gewandte Substratoberfläche vorgesehen ist.

In weiterer Ausgestaltung der Erfindung ist vorgesehen, dass das Fördermittel eine poröse Außenoberfläche aufweist, die insbesondere für einen Transport von Prozessmedium von zumindest einer im Fördermittel vorgesehenen Abgabestelle an die Außenoberfläche des Fördermittels ausgebildet ist, vorzugsweise durch Einleiten von druckbeaufschlagtem Prozessmedium in das Fördermittel. Mit einer porösen Oberfläche, die beispielsweise als Beschichtung des Fördermittels mit einer offenporigen, geschäumten Kunststoffmatrix oder als gesinterte, durch Verpressen von Metallpartikeln gebildete Schicht verwirklicht werden kann, ist die Übertragung eines auf der Außenoberfläche des Fördermittels anhaftenden Prozessmediumfilms zuverlässig gewährleistet. Das Prozessmedium kann in Poren der porösen Außenoberfläche des Fördermittels durch Oberflächenspannung gehalten werden und wird durch den mechanischen Kontakt zwischen der Außenoberfläche des Fördermittels und der Substratoberfläche zumindest teilweise auf die Substratoberfläche übertragen. Dabei stellen die Poren auch ein Reservoir für das Prozessmedium dar, so dass in dem zwischen Fördermittel und Substratoberfläche auftretenden Kapillarspalt eine vorteilhafte Verteilung des Prozessmediums gewährleistet werden kann.

Bei einer geschäumten, offenporigen Beschichtung in der Art eines insbesondere elastisch deformierbaren Schaumstoffs ist eine Beeinflussung von Porengröße und Porenverteilung durch die Auswahl geeigneter Polymermaterialien möglich. Bei einer gesinterten Schicht kann die Porengröße durch die Auswahl einer geeigneten Größe der Metallpartikel bestimmt werden, die für den Sintervorgang benutzt werden.

Bei einer bevorzugten Ausführungsform der Erfindung findet eine Zuführung von Prozessmedium durch eine im Fördermittel vorgesehene Abgabestelle auf die darauf angebrachte poröse Außenoberfläche statt. Eine derartige Zufuhr von Prozessmedium kann insbesondere mit Versorgungskanälen, die im Fördermittel vorgesehen sind und mit druckbeaufschlagtem Prozessmedium, das in die Versorgungskanäle eingeleitet wird, verwirklicht werden. Die Versorgungskanäle sind derart im Fördermittel angeordnet, dass sie im Bereich der porösen Außenoberfläche enden und somit einen Transport des flüssigen Prozessmediums an die Außenoberfläche gewährleisten. Mit einer derartigen Zuführung von Prozessmedium kann insbesondere eine besonders geringe Vernebelung des Prozessmediums gewährleistet werden, da lediglich zwischen Außenoberfläche und Substratoberfläche eine Relativbewegung im Sinne einer Abwälz- oder Abstreifbewegung stattfindet. Eine Relativbewegung zwischen dem Fördermittel und einem mit Prozessmedium gefüllten Becken oder ein Sprühvorgang für das Prozessmedium ist hingegen nicht notwendig. Damit kann eine besonders selektive Aufbringung des Prozessmediums auf die Substratoberfläche verwirklicht werden.

In weiterer Ausgestaltung der Erfindung ist vorgesehen, dass das Fördermittel eine Außenoberfläche mit einer Vielzahl von Durchgangsbohrungen aufweist, die vorzugsweise mit Versorgungskanälen zur Versorgung mit Prozessmedium von einer im Fördermittel vorgesehenen Abgabestelle verbunden sind. Die Durchgangsbohrungen können in eine geschlossene, aus Metall oder Kunststoff gefertigte Außenoberfläche des Fördermittels mittels konventioneller spanender Bearbeitung oder mit materialabtragenden Verfahren, insbesondere mit Laserbohren, eingebracht sein. Die Durchgangsbohrungen stehen mit Versorgungskanälen in Verbindung, die eine Versorgung der Außenoberfläche mit Prozessmedium über eine im Fördermittel vorgesehene Abgabestelle ermöglichen. Damit kann insbesondere eine gezielte Abgabe von Prozessmedium auf die Substratoberfläche bewirkt werden. Bei einer Ausführungsform der Erfindung sind die Versorgungskanäle derart mit der Abgabestelle, also beispielsweise einer Druckleitung für das Prozessmedium gekoppelt, dass jeweils einer oder wenige der Versorgungskanäle zeitgleich mit der Druckleitung verbunden sind, so dass zu einem Zeitpunkt nur ein Bereich der Außenoberfläche des Fördermittels mit Prozessmedium versorgt wird. Damit kann sichergestellt werden, dass nur der derjenige Bereich der Außenoberfläche über die Durchgangsbohrungen mit Prozessmedium versorgt wird, der unmittelbar in Berührkontakt mit der Substratoberfläche kommt.

In der Erfindung ist vorgesehen, dass das Fördermittel als Förderwalze ausgebildet ist, die derart angeordnet ist, dass sie die Transportebene tangiert. Eine Förderwalze weist eine im wesentlichen zylindrische Gestalt auf und ist drehbar an der Vorrichtung gelagert. Dabei ist eine Mittellängsachse der Förderwalze parallel zur Transportebene ausgerichtet und in etwa um einen Betrag von der Transportebene beabstandet, der einem Radius der Förderwalze entspricht. Damit berührt die Förderwalze die Transportebene tangential und ermöglicht eine linienförmige Berührung der Substratoberfläche. Durch die drehbare Lagerung der Förderwalze kann insbesondere eine gleichsinnige und gleich schnelle Oberflächengeschwindigkeit der Außenoberfläche der Förderwalze und der Substratoberfläche in der Transportebene erzielt werden, so dass ein im Wesentlichen reibungsfreier und zumindest nahezu schlupffreier Benetzungsvorgang durch Abwälzen der Außenoberfläche auf der Substratoberfläche verwirklicht werden kann. Damit ist ein Benetzungsvorgang für die Substratoberfläche sichergestellt, bei dem nur eine geringe Vernebelung von Prozessmedium stattfindet. Durch die Gestaltung der Fördereinrichtung als Förderwalze ist es möglich, eine extrem dünne Schicht der Prozessflüssigkeit flächig auf die Substratoberfläche aufzubringen, so dass bei sehr dünnen Substraten auch ein Übertreten des Prozessmediums auf andere, nicht zu benetzende Substratoberflächen nahezu ausgeschlossen werden kann.

In weiterer Ausgestaltung der Erfindung ist vorgesehen, dass die Förderwalze mit in Umfangsrichtung verlaufenden Rillen versehen ist. Dadurch kann in einfacher Weise eine Profilierung der Außenoberfläche der Förderwalze verwirklicht werden, wobei die in Umfangsrichtung verlaufenden Rillen für eine verbesserte Anhaftung des Prozessmediums sorgen. Bei der linienförmigen Berührung zwischen Förderwalze und Substratoberfläche wird durch die orthogonal zur Berührlinie verlaufenden Rillen eine flächige Versorgung mit Prozessmedium sichergestellt. Eine Rillentiefe kann in einem Bereich von 0,1mm bis 1mm, bevorzugt 0,2mm bis 0,8mm vorgesehen sein, wobei die Rillen eine einheitliche Tiefe oder unterschiedliche Rillentiefen aufweisen können.

In weiterer Ausgestaltung der Erfindung ist vorgesehen, dass die Förderwalze mit in Achsrichtung verlaufenden Rillen versehen ist. Dies ist insbesondere von Interesse, wenn die Förderwalze teilweise in ein mit Prozessmedium gefülltes Becken eingetaucht ist und aus diesem Becken das Prozessmedium mittels einer Rotationsbewegung fördert. Die in Achsrichtung verlaufenden Rillen verhindern, dass das Prozessmedium bei der Rotationsbewegung der Förderwalze vollständig von der Außenoberfläche der Förderwalze ablaufen kann und stellen somit eine ausreichende Versorgung mit Prozessmedium sicher.

In weiterer Ausgestaltung der Erfindung ist vorgesehen, dass die Förderwalze an einer Außenoberfläche eine Vielzahl von Vertiefungen, insbesondere Lochungen, aufweist. Die Vertiefungen, die durch spanende oder materialabtragende, insbesondere laseroptische oder chemische Verfahren in einer massiven Außenoberfläche der Förderwalze eingebracht werden können, ermöglichen ähnlich wie die Poren eine vorteilhafte Anhaftung des Prozessmediums an der Außenoberfläche und stellen somit eine Versorgung der Substratoberfläche mit Prozessmedium sicher. Die Vertiefungen können eine regelmäßige oder unregelmäßige Kontur aufweisen und können zwischen einer makroskopische Größe im Bereich von 1/10mm und einer mikroskopischen Größe im Bereich von wenigen 1/1000mm hinsichtlich Ausdehnung und Tiefe angesiedelt sein.

In weiterer Ausgestaltung der Erfindung ist vorgesehen, dass die Förderwalze derart an einem mit Prozessmedium befüllbaren Becken angebracht ist, dass eine Außenoberfläche der Förderwalze durch insbesondere ständiges Eintauchen in das Prozessmedium mit Prozessmedium benetzbar ist. Damit kann eine besonders einfache und zuverlässige Zuführung des Prozessmediums zur Förderwalze gewährleistet werden. Die Förderwalze ist derart an dem mit Prozessmedium gefüllten Becken angebracht, dass sie einen Flüssigkeitsspiegel des Prozessmediums zumindest tangiert. Bevorzugt ist die Förderwalze in das Prozessmedium eingetaucht und wird durch eine Antriebseinrichtung oder durch das Substrat in eine Rotationsbewegung versetzt, so dass ein ständiger Umlauf der Förderwalze im Prozessmedium stattfindet und die Förderwalze auch ständig mit Prozessmedium benetzt wird. Durch die Rotation der Förderwalze gelangen somit ständig frisch mit Prozessmedium benetzte Umfangsabschnitte der Außenoberfläche der Förderwalze in Berührkontakt mit der Substratoberfläche, so dass eine kontinuierliche und flächige Benetzung der in der Transportebene bewegten Substratoberfläche stattfinden kann.

In weiterer Ausgestaltung der Erfindung ist vorgesehen, dass die Förderwalze zumindest bis zu einem Drittel des Durchmessers oder bis zu einer Mittellängsachse in das Prozessmedium eingetaucht ist. Damit kann eine besonders vorteilhafte Benetzung der Außenoberfläche der Förderwalze sichergestellt werden. Die Förderwalze benötigt somit nur eine Rotation um einen Winkel von weniger als 90 Grad, um Prozessmedium vom Becken an die nach unten gewandte Substratoberfläche zu befördern.

In weiterer Ausgestaltung der Erfindung ist vorgesehen, dass die Förderwalze mit einer Antriebseinrichtung zur Übertragung einer Rotationsbewegung gekoppelt ist und als Transportmittel für die Substrate, vorzugsweise als einziges Transportmittel ausgebildet ist. Die Förderwalze wird neben der Förderung von Prozessmedium an die Substratoberfläche auch für eine Transportbewegung des Substrats eingesetzt und nimmt somit eine Doppelfunktion wahr. Dadurch lässt sich eine besonders einfache und kompakte Gestaltung der Vorrichtung zur Oberflächenbehandlung verwirklichen.

In der Erfindung ist vorgesehen, dass die Förderwalzen einen variierenden Durchmesser aufweisen mit mindestens zwei Bereichen größeren Durchmessers und wenigstens einem Bereich kleineren Durchmessers. Jeweils sind an den Seiten der Förderwalzen zwei Bereiche größeren Durchmessers vorgesehen mit dem anderen Bereich dazwischen. Die Bereiche größeren Durchmessers können etwa 1 bis 10mm, vorzugsweise 2 bis 5mm, über den Bereich geringeren Durchmessers überstehen. Die Bereiche größeren Durchmessers sind vorteilhaft erheblich schmaler als der andere, sie können beispielsweise mindestens 10mm, vorzugsweise 12 bis 30mm breit sein.

Es ist möglich, dass die Bereiche größeren Durchmessers wie vorbeschrieben für den Flüssigkeitstransport an die Unterseite der Substrate ausgebildet sind. Ein Bereich kleineren Durchmessers kann eine glatte und/oder geschlossene Oberfläche aufweisen.

In weiterer Ausgestaltung der Erfindung ist vorgesehen, dass mehrere Förderwalzen in Transportrichtung hintereinander angeordnet sind. Dadurch kann eine zuverlässige Benetzung der Substratoberfläche gewährleistet werden, da alle hintereinander angeordneten Förderwalzen in das mit dem Prozessmedium gefüllte Becken eingetaucht sind und somit eine mehrmalige Übertragung von Prozessmedium auf die Substratoberfläche stattfindet.

In weiterer Ausgestaltung der Erfindung ist vorgesehen, dass ein Prozessmedium vorgesehen ist, das als insbesondere wässrige Lösung mit zumindest einer der Substanzen Flusssäure (HF), Salzsäure HCl, Salpetersäure (HNO₃) Kalilauge (NaOH) ausgeführt ist. Damit können typische, bei der Herstellung von Halbleiter-Bauelementen oder Solarzellen aufgebrachte, elektrisch leitfähige Schichten von der Substratoberfläche abgetragen werden, um beispielsweise eine elektrische Verbindung von aktiven Bereichen des Substrats über die nach unten gewandte Substratoberfläche zu verhindern.

In weiterer Ausgestaltung der Erfindung ist vorgesehen, dass zumindest ein Absaugmittel zur Absaugung von gasförmig und/oder nebelartig verteiltem Prozessmedium aus der Umgebung des Fördermittels vorgesehen ist, wobei das zumindest eine Absaugmittel in vertikaler Richtung unterhalb der Transportebene angeordnet ist. Bei der Benetzung der nach unten gewandten Oberfläche des Substrats kann im Bereich der Fördereinrichtung verdampftes und/oder vernebeltes Prozessmedium auftreten, das sich in unerwünschter Weise auf anderen, nicht nach unten gewandten Oberflächen des Substrats niederschlagen kann. Um eine Beschädigung dieser gegebenenfalls ungeschützten Oberflächen durch das Prozessmedium zu verhindern, sind Absaugmittel vorgesehen, die das dampfförmig und/oder vernebelt vorliegende Prozessmedium aus der Umgebung der Fördereinrichtung absaugen und somit einen Niederschlag auf andere Substratoberflächen verhindern. Das zumindest eine Absaugmittel ist unterhalb der Transportebene angeordnet, um einen im Wesentlichen vertikal nach unten gerichteten Luftstrom hervorrufen zu können und damit ein Aufsteigen von verdampftem und/oder vernebeltem Prozessmedium über die Transportebene nach oben zu verhindern.

Typische Prozessmedien wie wässrige Lösungen von Flusssäure, Salzsäure, Salpetersäure oder Kalilauge bilden Gase oder Nebel, die schwerer als Luft sind und die in erster Linie durch die stattfindenden Relativbewegungen zwischen den Transportmitteln, den Fördermitteln und den Substraten über die Transportebene aufsteigen können. Das Absaugmittel basiert auf der Verwendung eines Unterdrucks, der bevorzugt derart gegenüber einem Normaldruck in der Umgebung der Fördereinrichtung gewählt ist, dass eine zumindest nahezu wirbelfreie, insbesondere laminare Luftströmung in vertikaler Richtung nach unten aufgebaut werden kann.

Die Aufgabe der Erfindung wird gemäß einem zweiten Aspekt durch eine Anlage mit den Merkmalen des Anspruchs 17 oder 18 gelöst. Erfindungsgemäß weist die Anlage wenigstens zwei vorbeschriebene Vorrichtungen auf, wobei die Substrate von der ersten Vorrichtung an die zweite Vorrichtung übergehen.

Einerseits sind dazu die erste und die zweite Vorrichtung so angeordnet, dass ihre Transportrichtungen um 90° zueinander verdreht sind. Bei einer Übergabe der Substrate von der ersten an die zweite Vorrichtung erfolgt dann automatisch die Änderung der Ausrichtung bzw. die Drehung relativ zur Transportrichtung.

Andererseits ist nach einer ersten Vorrichtung eine Drehstation vorgesehen, die die Substrate von der ersten Vorrichtung übernimmt und an die zweite Vorrichtung weitergibt, wobei die Drehstation die Substrate um 90° in der Transportebene dreht und dann gedreht an die zweite Vorrichtung weitergibt. Die beiden Vorrichtungen sind dann in einer Linie. Hierbei ist es erfindungsgemäß auch möglich, dass der Drehwinkel der Drehstation und der eingeschlossene Winkel und die Transportrichtungen der Vorrichtungen so ausgebildet sind, dass die Substrate nach dem Drehen und Weitergeben an die zweite Vorrichtung auf dieser um 90° verdreht liegen.

Die Drehstation kann zum Anheben und Drehen der Substrate ausgebildet sein und dazu Dreheinrichtungen aufweisen. Es können mehrere einzelne Dreheinrichtungen nebeneinander vorgesehen sein. Es ist möglich, dass benachbarte Dreheinrichtungen jeweils etwas nach vorne oder etwas nach hinten in Transportrichtung versetzt sind und insbesondere abwechselnd auf zwei Linien angeordnet sind, die senkrecht zur Transportrichtung verlaufen und beabstandet sind. So stören sich die Substrate nicht beim Drehen. Der gesamte Drehvorgang sollte möglichst schnell ablaufen, damit ein möglichst schneller Durchtransport der Substrate erfolgt.

Die Aufgabe der Erfindung wird gemäß einem dritten Aspekt durch ein Verfahren mit den Merkmalen des Anspruchs 21 zur Benetzung einer Substratoberfläche eines Substrats mit einem Prozessmedium gelöst mit den Schritten: Transport des Substrats mit Transportmitteln in einer Transportebene, Benetzung einer zumindest im Wesentlichen in der Transportebene angeordneten, nach unten weisenden Substratoberfläche mit einem Prozessmedium, das mit einer Fördereinrichtung in direktem mechanischen Kontakt an der Substratoberfläche aufgebracht wird.

Der Transport des Substrats erfolgt bevorzugt in einer im Wesentlichen geradlinigen Transportrichtung in der durch die Transportmittel bestimmten Transportebene. Zu diesem Zweck liegt das Substrat mit der nach unten gewandten Substratoberfläche auf einer Anordnung mehrerer in Transportrichtung hintereinander angeordneter Transportmittel auf. Die Transportmittel sind zumindest teilweise mit einer Antriebseinrichtung gekoppelt und werden von dieser angetrieben, so dass sie eine Vorwärtsbewegung des Substrats hervorrufen können. Die Benetzung der nach unten gewandten Substratoberfläche erfolgt unmittelbar durch die als Förderwalzen gestalteten Transportmittel, die damit auch als Fördermittel für das Prozessmedium dienen. Ergänzend bzw. alternativ kann die Benetzung auch durch separate Fördermittel, die zwischen den Transportmitteln unterhalb der Transportebene angeordnet sind, erfolgen.

In weiterer Ausgestaltung der Erfindung ist vorgesehen, dass eine von der Förderwalze auf die Substratoberfläche aufbringbare Prozessmediummenge durch eine Variation einer Eintauchtiefe der Förderwalze in das Prozessmedium und/oder durch eine Variation einer Rotationsgeschwindigkeit der Förderwalze eingestellt wird. Eine Variation der Eintauchtiefe der Förderwalze wird praktisch durch eine Variation der Befüllung des Beckens mit Prozessmedium vorgenommen, so dass ein Abstand zwischen dem Flüssigkeitsspiegel des Prozessmediums im Becken und der Transportebene eingestellt werden kann. Dieser Abstand bestimmt, über welchen Drehwinkel das Prozessmedium von der Förderwalze zwischen Flüssigkeitsspiegel und Substratoberfläche gefördert werden muss. Bei einem maximalen Abstand von Flüssigkeitsspiegel und Transportebene, bei dem die Förderwalze sowohl die Transportebene als auch den Flüssigkeitsspiegel tangiert, liegt bei waagerecht ausgerichteter Transportebene ein Drehwinkel von 180 Grad vor. Bei Reduzierung des Abstands zwischen dem Flüssigkeitsspiegel und der Transportebene wirkt der Flüssigkeitsspiegel wie eine Sekante an der zylindrischen Förderwalze, so dass der Drehwinkel, über den das Prozessmedium frei zwischen Flüssigkeitsspiegel und Substratoberfläche gefördert werden muss, verringert wird. Beispielsweise beträgt der Drehwinkel bei einer bis zu einem Drittel des Durchmessers in das Prozessmedium eingetauchten Förderwalze 90 Grad. Je kleiner der Drehwinkel ist, desto mehr Prozessmedium gelangt bei gleichbleibender Rotationsgeschwindigkeit der Förderwalze an die Substratoberfläche.

Durch die Variation der Rotationsgeschwindigkeit kann ebenfalls eine Beeinflussung der zur Verfügung gestellten Prozessmediummenge vorgenommen werden. Im Unterschied zum Drehwinkel liegt für die Rotationsgeschwindigkeit ein von Null verschiedener Rotationsgeschwindigkeitsbereich vor, bei dem eine maximale Menge an Prozessmedium von der Förderwalze gefördert werden kann. Bei geringerer Rotationsgeschwindigkeit fließt das Prozessmedium im Wesentlichen in das Becken ab, während es bei höherer Rotationsgeschwindigkeit weggeschleudert werden kann. Bei einer bevorzugten Ausführungsform der Erfindung ist eine Steuer- oder Regeleinrichtung vorgesehen, die in Abhängigkeit vom Prozessmedium und von den zu behandelnden Substraten eine Steuerung oder Regelung der Rotationsgeschwindigkeit und/oder der Eintauchtiefe bzw. des Flüssigkeitsspiegels ermöglicht.

In weiterer Ausgestaltung der Erfindung ist vorgesehen, dass durch eine Absaugung von verdampftem und/oder vernebeltem Prozessmedium vor und/oder während und/oder nach der Benetzung der Substratoberfläche mit in vertikaler Richtung unterhalb der Transportebene angeordneten Absaugmitteln ein Niederschlag des Prozessmediums auf anderen Substratoberfläche als der in der Transportebene angeordneten Substratoberfläche verhindert wird. Eine Absaugung von verdampftem und/oder vernebeltem Prozessmedium wird durch Absaugmittel bewirkt, die in vertikaler Richtung unterhalb der Transportebene angeordnet sind und einen Luftstrom in vertikaler Richtung nach unten bewirken, um einen Niederschlag des Prozessmediums auf andere als die in der Transportebene angeordneten Substratoberfläche zu verhindern.

In weiterer Ausgestaltung der Erfindung ist vorgesehen, dass ein kontinuierlicher Transport von Substrat und/oder eine kontinuierliche Bereitstellung von Prozessmedium durch die Fördereinrichtung zur Benetzung der Substratoberfläche und/oder eine kontinuierliche Absaugung von gasförmigem oder vernebeltem Prozessmedium durchgeführt wird. Durch eine kontinuierliche Durchführung des Transports der Substrate und/oder der Bereitstellung von Prozessmedium zur Benetzung der Substratoberfläche und/oder der Absaugung kann ein Bearbeitungsprozess gewährleistet werden, bei dem nur ein minimaler, vorzugsweise ein verschwindender, besonders bevorzugt kein Niederschlag von Prozessmedium auf nicht zu benetzenden Substratoberflächen stattfindet.

In weiterer Ausgestaltung der Erfindung kann die Aufbringung von Prozessmedium an der nach unten weisenden Substratoberfläche nur im Randbereich der Substrate erfolgen. Ein solcher Randbereich kann 5 bis 15mm betragen. Vorteilhaft wird dabei das Prozessmedium auf die in Transportrichtung links und rechts liegenden Seiten von rechteckigen Substraten aufgebracht wird, wobei dazu vorbeschriebene Förderwalzen verwendet werden können mit Bereichen größeren Durchmessers am Rand und kleineren Durchmessers in der Mitte.

Die Substrate können zuerst mit einer ersten Orientierung bzw. Ausrichtung transportiert werden und zur Benetzung der Ränder der nach unten weisenden Substratoberfläche mit Prozessmedium. Dann erfolgt eine Drehung der Substrate um 90° in der Transportebene und dann erfolgt eine erneute Benetzung der Ränder der nach unten weisenden Substratoberfläche an den beiden übrigen Seitenflächen. So werden jeweils die Randbereiche benetzt und geätzt.

Einerseits kann das Drehen der Substrate außerhalb der Vorrichtungen mit dem Prozessmedium erfolgen, beispielsweise wie vorbeschrieben an einer Drehstation zwischen zwei Vorrichtungen. Andererseits können die Substrate von einer Vorrichtung an eine weitere derartige Vorrichtung übergeben werden, wobei die Vorrichtungen mit einem Winkel von 90° zueinander stehende Transportrichtungen aufweisen und die Substrate auf den Vorrichtungen in jeweils unterschiedliche Transportrichtungen transportiert werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen gebieten verwirklicht sein und vorteilhafte sowie für sich schutzfähige Ausführungen darstellen können, für die hier Schutz beansprucht wird, die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. Dabei zeigt:
- Fig. 1: eine schematische Darstellung einer Vorrichtung zur Oberflächen- behandlung von Substraten in einer Seitenansicht,
- Fig. 2: eine schematische Darstellung der Vorrichtung gemäß Fig. 1 in einer teilweise geschnittenen Vorderansicht,
- Fig. 3: eine vergrößerte Darstellung einer als Transportwalze ausgeführ- ten Förderwalze aus der Vorrichtung gemäß den Fig. 1 und 2,
- Fig. 4: eine Darstellung, wie zwei Vorrichtungen entsprechend Figur 1 in einer Linie aufgestellt sind mit einer Drehstation für die Substrate dazwischen und
- Fig. 5: eine Ansicht ähnlich Fig. 2 auf zwei Förderwalzen gemäß einem zweiten Aspekt der Erfindung.

### Detaillierte Beschreibung der Ausführungsbeispiele

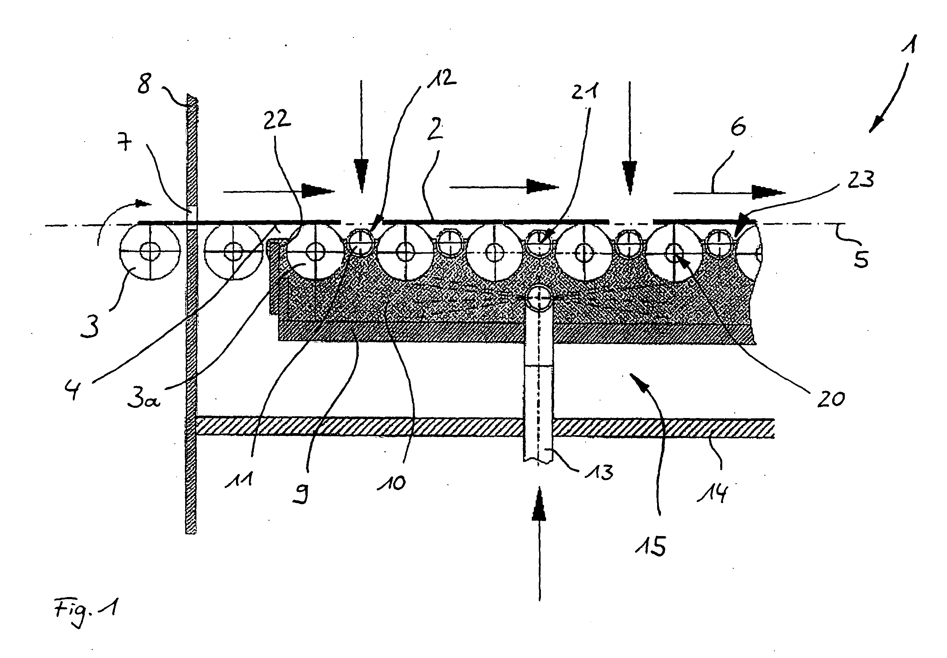

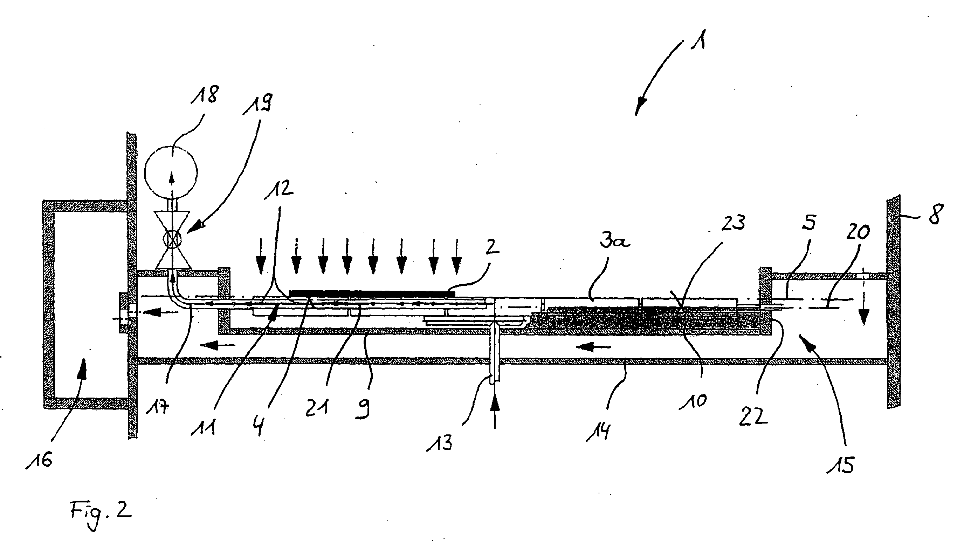

Eine in den Fig. 1 und 2 dargestellte Vorrichtung 1 zur Oberflächenbehandlung von Substraten 2 weist mehrere als Transportrollen 3, 3a ausgeführte Transportmittel auf. Die Transportrollen 3, 3a sind für einen linearen Transport der insbesondere aus Siliziumwerkstoff hergestellten Substrate 2 vorgesehen und abgestimmt. Die Transportrollen 3, 3a begrenzen eine Transportebene 5, die in horizontaler Richtung ausgerichtet ist und die die Transportrollen 3, 3a an einer Oberfläche tangiert. Die Transportrollen 3, 3a sind drehbeweglich in der Vorrichtung 1 gelagert und werden zumindest teilweise von einer nicht dargestellten Antriebseinrichtung mit einer vorzugsweise konstanten, einstellbaren Rotationsgeschwindigkeit angetrieben.

Das Substrat 2 ist typischerweise eine flache, ebene Siliziumplatte, die eine runde Kontur mit einem Durchmesser von ungefähr 60mm bis 250mm oder eine rechteckige Kontur mit Kantenlängen von 60mm bis 250mm aufweist. Eine bevorzugte Dicke des Substrats liegt im Bereich von 0,1mm bis 2mm. Das Substrat 2 liegt mit einer nach unten gewandten Substratoberfläche 4 auf den Transportrollen 3, 3a auf und wird durch die gleichsinnige und gleich schnelle Rotation der Transportrollen 3, 3a in einer Transportrichtung 6 bewegt.

Die Aufgabe der Vorrichtung 1 kann beispielsweise darin bestehen, eine allseitig auf das Substrat 2 aufgetragene, insbesondere elektrisch leitfähige Beschichtung an der nach unten gewandten Substratoberfläche 4 in einem nasschemischen Verfahren unter Verwendung eines flüssigen Prozessmediums zu entfernen, ohne die auf den übrigen Oberflächen des Substrats aufgetragene Beschichtung zu beschädigen.

Zu diesem Zweck wird das Substrat 2 mit der Substratoberfläche 4 auf die Transportrollen 3, 3a aufgelegt und durch eine Eingangsöffnung 7 in eine zeichnerisch nur angedeutete, zumindest nahezu vollständig geschlossene Prozesskammer 8 bewegt. In der Prozesskammer 8 ist ein Becken 9 vorgesehen, das vollständig mit einem flüssigen Prozessmedium 10, insbesondere mit wässrigen Lösungen von Flusssäure (HF_{(aq)}) und/oder Salzsäure (HCl_{(aq)}) und/oder Salpetersäure (HNO_{3(aq)}) und/oder Kalilauge (NaOH_{(aq)}) gefüllt sein kann. Das Becken 9 ist mit Abstand zu einem Boden 14 der Prozesskammer 8 angeordnet, so dass zwischen Becken 9 und Boden 14 ein Absaugschacht 15 gebildet ist, der eine Absaugung am Randbereich des Beckens 9 gewährleistet. Wie in der Fig. 2 näher dargestellt, erstreckt sich der Absaugschacht 15 unterhalb des gesamten Beckens 9 und ermöglicht damit eine Absaugung von gasförmigem und/oder vernebeltem Prozessmedium 10, das über den Rand des Beckens 9 hinaustritt und nicht von den Absaugmitteln 11 erfasst wird. Der Absaugschacht 15 ist mit einem seitlich an der Vorrichtung 1 angebrachten Abluftschacht 16 gekoppelt, der mit Unterdruck beaufschlagt ist. Eine Versorgung des Beckens 9 mit frischem Prozessmedium 10 ist über eine Medienleitung 13 vorgesehen.

Um eine Benetzung der nach unten gewandten Substratoberfläche 4 zu gewährleisten, nehmen die Transportrollen 3a eine Doppelfunktion ein, das heißt, sie dienen nicht nur als Transportmittel für das Substrat 2, sondern auch als Fördereinrichtung für das Prozessmedium 10. Für eine Förderung des Prozessmediums 10 aus dem Becken 9 in die Transportebene 5 sind die Transportrollen 3a derart in dem Becken 9 angebracht, dass sie teilweise in das Prozessmedium 10 eingetaucht sind und ein Flüssigkeitsspiegel 23 oberhalb einer Rotationsachse 20 der zylindrischen Förderwalzen 3a liegt. Die als Förderwalzen 3a ausgeführten Transportrollen weisen eine benetzbare Oberfläche auf, so dass sie das Prozessmedium 10 in geringer Schichtstärke entgegen der Schwerkraft nach oben in die Transportebene 5 befördern können und in einem Abwälzvorgang, das heißt in einem direkten mechanischen Kontakt auf die Substratoberflächen 4 übertragen können. Da das Prozessmedium 10 nur in geringer Schichtstärke auf den Transportrollen 3a aufliegt, wird selbst bei einer geringen Dicke der Substrate 2 sichergestellt, dass das Prozessmedium 10 nicht auf eine nach oben gewandte Substratoberfläche gelangt.

Um sicherzustellen, dass die nach oben gewandte Substratoberfläche frei von Prozessmedium 10 bleibt, sind Absaugmittel 11 zur Absaugung von gasförmigem und/oder nebelartigem Prozessmedium, das in der Umgebung der als Fördermittel wirkenden Transportrollen 3a vorliegen kann, vorgesehen. Das Prozessmedium 10 weist einen Dampfdruck auf, der sich darin äußert, dass das Prozessmedium 10 in Abhängigkeit von den umgebenden atmosphärischen Bedingungen wie beispielsweise einer Umgebungstemperatur und einem Luftdruck mehr oder weniger stark verdampft und sich mit der Umgebungsluft vermengt. Zudem kann durch die Relativbewegung zwischen den Transportrollen 3a und dem Prozessmedium 10 und durch Abwälzvorgänge der Fördermittel 3a auf der Substratoberfläche 4 auch eine Ablösung von kleinsten Prozessmediumtröpfchen stattfinden, die als fein verteilter Nebel oberhalb des Flüssigkeitsspiegels des Prozessmediums 10 vorliegen. Zwar ist ein Gemisch aus gasförmigem und/oder vernebeltem Prozessmedium 10 mit der Umgebungsluft typischerweise schwerer als die Umgebungsluft. Es findet jedoch durch die Relativbewegungen der Fördermittel 3a und der Substrate 2 eine Verwirbelung der Umgebungsluft statt, die ohne Absaugmittel 11 zu einem Aufsteigen des gasförmigen und/oder vernebelten Prozessmediums über die Transportebene 5 führen kann.

Somit könnte sich gasförmiges und/oder vernebeltes Prozessmedium 10 auf der nach oben gewandten Oberfläche des Substrats 2 niederschlagen. Da dies nicht gewünscht ist, sind die Absaugmittel 11 vorgesehen, die als mit Unterdruck beaufschlagte Rohre zwischen den Transportrollen 3a angebracht sind und die jeweils mehrere Ansaugöffnungen 12 aufweisen, durch die das gasförmige und/oder vernebelte Prozessmedium 10 in einem Bereich unterhalb der Transportebene 5 abgesaugt werden kann und somit nicht über die Transportebene 5 hinaus auf die nach oben gewandte Substratoberfläche gelangen kann. Aus diesem Grund sind die Absaugmittel 11 in vertikaler Richtung unter der Transportebene 5 angeordnet, sie bewirken einen im Wesentlichen in vertikaler Richtung strömenden Luftstrom, der bevorzugt wirbelarm und besonders bevorzug laminar ausgebildet ist.

Die Absaugmittel 11 sind über ein Ableitungsrohr 17 mit einer Absaugleitung 18 verbunden, die über eine nicht dargestellte Pumpeinrichtung mit einem Unterdruck beaufschlagt ist. Zur individuellen Einstellung eines Absaugmittels 11 ist zwischen Ableitungsrohr 17 und Absaugleitung 18 ein Einstellventil 19 vorgesehen, das als Drosselventil ausgebildet ist und das eine Beeinflussung eines von der Absaugleitung 18 angesaugten Volumenstroms ermöglicht.

Für eine besonders kompakte Anordnung der Absaugmittel 11 in der Vorrichtung 1 ist vorgesehen, eine Mittellängsachse 21 der röhrenförmig ausgeführten Absaugmittel 11 parallel zu einer Rotationsachse 20 der Transportrollen 3a auszurichten und die Absaugmittel 11 in einem von den Transportrollen 3a und der Transportoberfläche 5 sowie nach unten vom Flüssigkeitsspiegel des Prozessmediums 10 begrenzten Zwischenraum anzuordnen. Damit kann trotz einer geringen Beabstandung der Transportrollen 3 ein großer Querschnitt für die Absaugmittel 11 verwirklicht werden. So kann selbst bei großen Volumenströmen, die durch die Absaugmittel 11 abgesaugt werden, eine geringe Strömungsgeschwindigkeit in den Absaugmitteln 11 gewährleistet werden. Zudem liegt auch eine große Außenoberfläche der Absaugmittel 11 vor, in die eine große Anzahl von Ansaugöffnungen 12 eingebracht werden können, um im Ergebnis eine wirbelarme, insbesondere laminare Luftströmung in vertikaler Richtung nach unten verwirklichen zu können, die eine zuverlässige Absaugung von gasförmig oder nebelartig verteiltem Prozessmedium 10 gewährleistet.

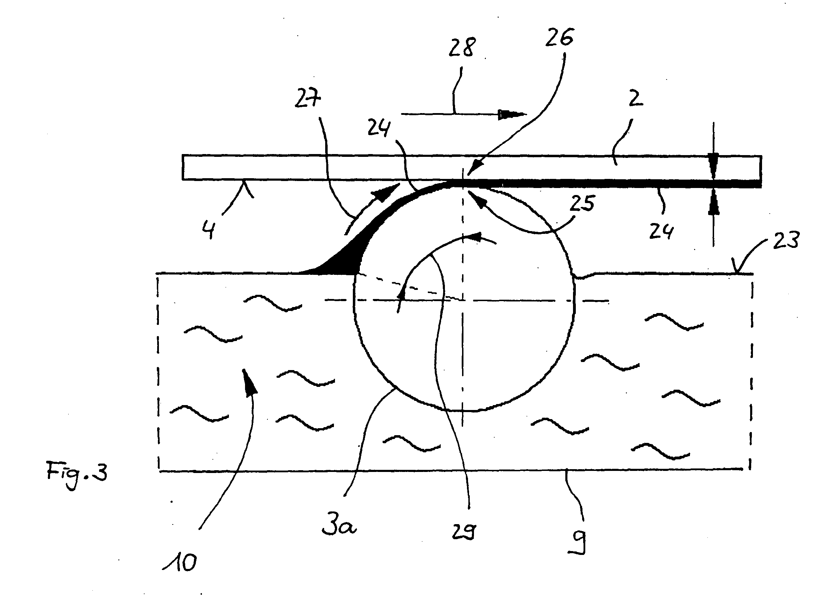

Gemäß der Darstellung der Fig. 3, die eine schematische Ausschnittvergrößerung der in den Fig. 1 und 2 dargestellten, als Transportwalzen ausgeführten Förderwalzen 3a zeigt, ist erkennbar, wie das Prozessmedium 10 aus dem Becken 9 über den Flüssigkeitsspiegel 23 hinaus durch die Rotation der Transportwalze 3a in Richtung der nach unten gewandten Substratoberfläche 4 gefördert wird und im direkten mechanischen Kontakt die Substratoberfläche 4 mit Prozessmedium 10 benetzt. Die teilweise in das Prozessmedium 10 eingetauchte Förderwalze 3a ist in einem eingetauchten Abschnitt vollständig von dem Prozessmedium 10 umgeben und damit benetzt. Durch die Rotation der Förderwalze 3a kann ein dünner Prozessmediumfilm 24 von der Förderwalze 3a in Rotationsrichtung 27 mitgenommen werden. Durch die Gestaltung der Außenoberfläche der Förderwalze 3a, insbesondere durch eine geeignete Materialauswahl und eine gegebenenfalls vorgesehene Strukturierung, das heißt durch Poren, Rillen oder Vertiefungen, kann eine Dicke des Prozessmediumfilms 24 bestimmt werden, der beim Austreten des jeweiligen Förderwalzenabschnitts aus dem Prozessmedium 10 mitgenommen werden kann und der auf die Substratoberfläche 4 zumindest teilweise übertragen wird. Zudem hängt die Dicke des Prozessmediumfilms 24 von einer Eintauchtiefe in das Prozessmedium 10 und einem davon bestimmten freien Drehwinkel 29 sowie von einer Rotationsgeschwindigkeit der Förderwalze 3a ab, die auch die Transportgeschwindigkeit des Substrats 2 in die Transportrichtung 28 bestimmt. Das Prozessmedium 10 wird an einer in die Darstellungsebene erstreckte, linienförmigen Berührstelle 26 auf die nach unten weisende Substratoberfläche 4 übertragen, wobei sich an der Berührstelle 26 durch das Eigengewicht des Substrats 2 und die Eigenschaften der Substratoberfläche 4 und des Prozessmediums 10, insbesondere die Benetzbarkeit der Substratoberfläche 4 und die Oberflächenspannung des Prozessmediums 10, ein zumindest nahezu vollständig flüssigkeitsgefüllter Kapillarspalt 25 ausbildet, der für eine gleichmäßige Verteilung des Prozessmediums 10 auf der Substratoberfläche 4 verantwortlich ist. Durch die direkte mechanische Übertragung des Prozessmediums 10 auf die Substratoberfläche 4 kann eine vorteilhafte und vernebelungsarme und verdunstungsarme Benetzung der Substratoberfläche 4 gewährleistet werden, so dass eine selektive Oberflächenbehandlung des Substrats 2 sichergestellt ist.

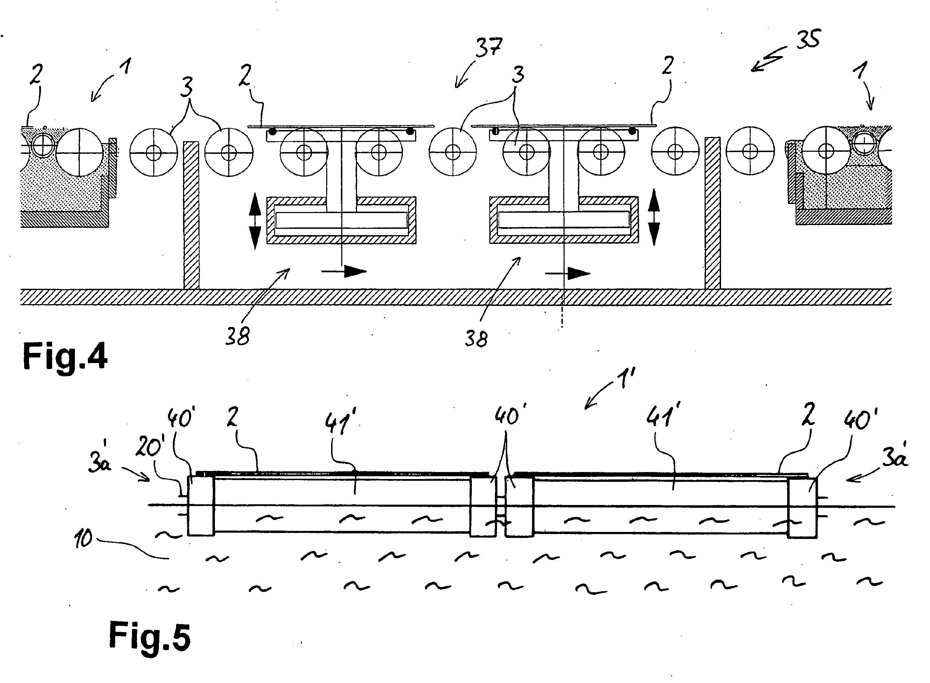

In Fig. 4 ist dargestellt, wie eine Anlage 35 mit zwei Vorrichtungen 1 gemäß Fig. 1 aufgebaut ist. Die Vorrichtungen 1 stehen dabei in einer Linie und weisen einen erheblichen Abstand zueinander auf, wobei dazwischen eine Drehstation 37 vorgesehen ist. Der Transportweg für die Substrate 2 zwischen den beiden Vorrichtungen 1 weist weitere Transportrollen 3 auf, die die Substrate 2 auf gleicher Höhe und in gleicher Richtung weitertransportieren. Die Drehstation 37 weist mehrere Dreheinrichtungen 38 auf, die erkennbar für das Anheben der Substrate ausgebildet sind. Dabei werden die Substrate von den Transportrollen 3 abgehoben, um 90° gedreht und dann wieder auf den Transportrollen 3 abgesetzt für einen Weitertransport von der linken Vorrichtung 1 zu der rechten Vorrichtung 1. Das Anheben erfolgt vorteilhaft mit Luftdruck, wobei gleichzeitig die Substrate 2 mit ihren Unterseiten an den Dreheinrichtungen 38 festgesaugt sein können. Derartige Dreheinrichtungen sind an sich für den Fachmann bekannt, sowohl hinsichtlich des Anhebens als auch hinsichtlich des Drehens, so dass hierfür keine weiteren Erläuterungen notwendig sind. Zu der Drehstation 37 ist noch anzuführen, dass die Dreheinrichtungen 38 quer zur von links nach rechts gehenden Transportrichtung so angeordnet sind, dass mehrere in nebeneinander liegenden Bahnen transportierte Substrate 2 je von einer Dreheinrichtung 38 gedreht werden. Damit sich die Substrate 2 bzw. die Drehstationen 38 dabei nicht behindern, sind die benachbarten Drehstationen eben jeweils nach vorne und nach hinten versetzt zueinander.

In Fig. 5 ist eine alternative Ausführung einer Vorrichtung 1' ähnlich derjenigen aus Fig. 2 in vergrößerter Darstellung gezeigt. Auf einer Rotationsachse 20 drehen sich Förderwalzen 3a', wobei sie ungefähr bis zur Hälfte in Prozessmedium 10 eingetaucht sind. Die Förderwalzen 3a' weisen an den Enden verdickte Randbereiche 40' auf mit etwas dünneren Mittelbereichen 41' dazwischen. Die Förderwalzen 3a' sind dabei bezüglich der Randbereiche 40' so ausgebildet, dass die Substrate 2 jeweils außen auf dem Randbereich 40' aufliegen und im wesentlichen Mittelbereich jedoch frei verlaufen. Dadurch können auch nicht völlig plane Substrate 2, die beispielsweise aufgrund des Herstellungs- oder Bearbeitungsverfahrens leicht uneben oder gewellt sind, unter permanenter und guter Auflage auf den Förderwalzen 3a' bzw. den Randbereichen 40' mit dem Prozessmedium 10 benetzt werden. Wie zuvor beschrieben worden ist, ist gerade an den Außenbereichen bzw. den Kanten der Substrate das Ätzen und somit auch das Benetzen mit Prozessmedium 10 sehr wichtig. Wären die Substrate 2 beispielsweise in der Mitte nach unten durchgebogen, so würde an mindestens einem Randbereich kein Kontakt mehr zu der Förderwalze stattfinden und somit hier auch kein Ätzvorgang. Dies wird eben durch die sozusagen taillierten Förderwalzen 3a' bzw. deren dünnere Mittelbereiche 41' erreicht.

Während die Ausbildung der Mittelbereiche 41' bezüglich ihrer Flüssigkeitsaufnahmefähigkeit oder Transportfähigkeit für die Flüssigkeit 10 ohne Belang ist, sind die Randbereiche 40' vorteilhaft so ausgebildet wie für die vorherige Ausführung hinsichtlich der gesamten Förderwalze 3a beschrieben worden ist. Insofern wird einfach darauf verwiesen. Der Dickenunterschied bzw. Durchmesserunterschied zwischen den Randbereichen 40' und den Mittelbereichen 41' kann einige Millimeter betragen, beispielsweise auch 2 bis 10% des Durchmessers ausmachen.

Da aus Fig. 5 deutlich wird, dass die Substrate 2 nur an den in Transportrichtung seitlich liegenden Außenbereichen geätzt werden, und die vorderen und hinteren Außenbereiche nicht geätzt werden, muss dies noch erfolgen. Dafür ist eben die Anordnung gemäß Fig. 4 mit der Anlage 35 von großem Nutzen, da dort in der linken Vorrichtung 1 das eine Paar von gegenüberliegenden seitlichen Außenbereichen oder Kanten geätzt wird. Durch die Drehstation 37 mit den Dreheinrichtungen 38 werden die Substrate 2 um 90° in der Transportebene gedreht und wieder abgesetzt. Mit den Transportrollen 3 werden sie zu der rechten Vorrichtung 1 transportiert und dort dann wiederum die beiden übrigen Außenbereiche geätzt. Selbstverständlich ist die Ausführung gemäß Fig. 5 mit den in einem Mittelbereich 41' dünneren Förderwalzen 3a' nicht nur bei gebogenen oder gewölbten Substraten 2 vorteilhaft verwendbar, sondern auch bei planen. Dies ist vom Einzelfall abhängig, wie eben die besten Resultate erzielt werden können.

In weiterer Ausgestaltung ist es auch möglich, dass die Randbereiche 40' nicht fix an den Förderwalzen 3a' befestigt sind, sondern beispielsweise auch verschoben werden können, so dass eine Überlappung von beispielsweise 10 mm zwischen Substrat 2 und Randbereich 40' mit der Auflage gegeben sind. So könnten allgemein durch nach Art von Ringen odgl. ausgebildete Randbereiche 40', die auf den Förderwalzen 3a' entlang der Rotationsachse 20' verschoben werden können, verschiedene Substrate 2 behandelt werden bzw. eine Anpassung der erfindungsgemäßen Anlage 1' an verschiedene Breiten von Substraten stattfinden.

## Patentansprüche

1. Vorrichtung (1') zur Oberflächenbehandlung von Substraten (2), mit Transportmitteln (3a') zum Transport eines Substrats (2) in einer von den Transportmitteln (3a') bestimmten Transportebene (5) und mit zumindest einem Fördermittel (3a'), das für eine Benetzung des Substrats (2) mit einem flüssigen Prozessmedium (10) ausgebildet ist, wobei das Fördermittel (3a') derart unterhalb der Transportebene (5) angeordnet ist, dass es die Transportebene (5) berührt oder zumindest nahezu an die Transportebene (5) heranreicht zur Benetzung der nach unten gerichteten Substratoberfläche (4) mit Prozessmedium (10) in direktem Kontakt zwischen Fördermittel (3a') und Substratoberfläche (4), wobei das Fördermittel (3a') als Förderwalze ausgebildet ist, die derart angeordnet ist, dass sie die Transportebene (5) tangiert, **dadurch gekennzeichnet, dass** die Förderwalzen (3a') einen variierenden Durchmesser aufweisen mit mindestens zwei Bereichen (40') größeren Durchmessers, die wenigstens einen Bereich (41') kleineren Durchmessers überstehen, wobei die zwei Bereiche (40') größeren Durchmessers jeweils an den Seiten der Förderwalzen (3a') vorgesehen sind.

2. Vorrichtung nach Anspruch 1, **dadurch gekennzeichnet, dass** dem Fördermittel (3a') eine Zuführeinrichtung (9) für die Zuführung von Prozessmedium (10) auf eine Außenoberfläche des Fördermittels (3a') zugeordnet ist.

3. Vorrichtung nach Anspruch 1 oder 2, **dadurch gekennzeichnet, dass** das Fördermittel (3a') eine poröse Außenoberfläche aufweist, die insbesondere für einen Transport von Prozessmedium (10) von zumindest einer im Fördermittel (3a') vorgesehenen Abgabestelle an die Außenoberfläche des Fördermittels (3a') ausgebildet ist, vorzugsweise durch Einleiten von druckbeaufschlagtem Prozessmedium in das Fördermittel (3a)

4. Vorrichtung nach Anspruch 1, **dadurch gekennzeichnet, dass** die Bereiche (40') größeren Durchmessers etwa 1 bis 10 mm, vorzugsweise 2 mm bis 5 mm, über den wenigstens einen Bereich (41') geringeren Durchmessers überstehen.

5. Vorrichtung nach Anspruch 1 oder 4, **dadurch gekennzeichnet, dass** die Bereiche (40') größeren Durchmessers mindestens 10, vorzugsweise 12 bis 30 mm breit sind.

6. Anlage (35) mit wenigstens zwei Vorrichtungen ( 1') nach einem der vorhergehenden Ansprüche, **dadurch gekennzeichnet, dass** eine erste Vorrichtung (1') mit einer ersten Transportrichtung vorgesehen ist und daran anschließend eine zweite Vorrichtung (1') mit einer zweiten Transportrichtung, wobei die Substrate (2) von der ersten Vorrichtung an die zweite Vorrichtung übergehen, wobei die erste Transportrichtung um 90° zu der zweiten Transportrichtung verdreht ist.

7. Anlage (35) mit wenigstens zwei Vorrichtungen (1') nach einem der Ansprüche 1 bis 5, **dadurch gekennzeichnet, dass** nach einer Vorrichtung (1') eine Drehstation (37) vorgesehen ist, die die Substrate (2) von der ersten Vorrichtung übernimmt und an die zweite Vorrichtung weitergibt, wobei die Substrate (2) auf der zweiten Vorrichtung im Vergleich zur ersten Vorrichtung um 90° in der Transportebene (5) gedreht sind.

8. Anlage (35) nach Anspruch 7, **dadurch gekennzeichnet, dass** die Drehstation (37) selber die Substrate (2) dreht, insbesondere um 90° in der Transportebene (5), wobei sie zum Anheben und Drehen der Substrate (2) ausgebildet ist bzw. dazu Dreheinrichtungen (38) vorgesehen sind.

9. Anlage nach Anspruch 7 oder 8, **dadurch gekennzeichnet, dass** die Drehstation (37) mehrere einzelne Dreheinrichtungen (38) nebeneinander aufweist, wobei vorzugsweise benachbarte Dreheinrichtungen (38) jeweils etwas nach vorne oder etwas nach hinten in Transportrichtung versetzt sind und insbesondere die Dreheinrichtungen (38) abwechselnd auf zwei Linien angeordnet sind, die senkrecht zur Transportrichtung verlaufen und beabstandet sind.

10. Verfahren zur Benetzung einer Substratoberfläche (4) eines Substrats mit einer Vorrichtung nach einem der vorhergehenden Ansprüche (2) mit einem Prozessmedium (10) mit den Schritten :
- Transport des Substrats (2) mit Transportmitteln (3a') in einer Transportebene (5),
- Benetzung einer zumindest im Wesentlichen in der Transportebene (5) angeordneten, nach unten weisenden Substratoberfläche (4) mit einem Prozessmedium (10), das mit einer Fördereinrichtung (3a') in direktem mechanischen Kontakt an der Substratoberfläche (4) aufgebracht wird, wobei die Aufbringung von Prozessmedium (10) an der nach unten weisenden Substratoberfläche im Randbereich der Substrate (2) erfolgt, vorzugsweise in einem Randbereich von 5 bis 15 mm.

11. Verfahren nach Anspruch 10, **gekennzeichnet durch** eine Absaugung von verdampftem oder vernebeltem Prozessmedium (10) vor, während oder nach der Benetzung der Substratoberfläche (4) mit in vertikaler Richtung unterhalb der Transportebene (5) angeordneten Absaugmitteln (11), um einen Niederschlag des Prozessmediums (10) auf der anderen Substratoberfläche als der in der Transportebene (5) angeordneten Substratoberfläche (4) zu verhindern.

12. Verfahren nach Anspruch 10 oder 11, **dadurch gekennzeichnet, dass** das Prozessmedium (10) auf die in Transportrichtung links und rechts liegenden Seiten von rechteckigen Substraten (2) aufgebracht wird, insbesondere mit Förderwalzen (3a') gemäß einem der Ansprüche 1 bis 5.

13. Verfahren nach Anspruch 10 oder 12, **dadurch gekennzeichnet, dass** die Substrate (2) zuerst mit einer ersten Orientierung bzw. Ausrichtung transportiert werden und dabei die Ränder der nach unten weisenden Substratoberfläche mit Prozessmedium (10) benetzt werden, dann eine Drehung der Substrate (2) um 90° in der Transportebene erfolgt und dann eine erneute Benetzung der Ränder der nach unten weisenden Substratoberfläche an den beiden übrigen Seitenflächen erfolgt.

14. Verfahren nach Anspruch 13, **dadurch gekennzeichnet, dass** das Drehen der Substrate (2) außerhalb der Vorrichtungen (1') mit dem Prozessmedium (10) erfolgt, insbesondere an einer Drehstation (37) zwischen zwei Vorrichtungen (1') mit Prozessmedium (10).

15. Verfahren nach Anspruch 13 oder 14, **dadurch gekennzeichnet, dass** die Substrate (2) von einer Vorrichtung (1') gemäß einem der Ansprüche 1 bis 6 an eine weitere derartige Vorrichtung (1') übergeben werden, wobei die Vorrichtungen (1') mit einem Winkel von 90° zueinander stehende Transportrichtungen aufweisen und die Substrate (2) auf den Vorrichtungen (1') in jeweils unterschiedliche Transportrichtungen transportiert werden.

## Claims

1. Device (1') for the surface treatment of substrates (2), with transport means ( 3a') for transporting a substrate (2) in a transport plane (5) defined by transport means (3a') and with at least one conveying means (3a'), which is constructed for a wetting of substrate (2) with a liquid process medium (10), the conveying means (3a') being positioned below the transport plane (5) in such a way that it touches or at least extends close to the transport plane (5) for wetting the downwardly directed substrate surface (4) with process medium (10) in direct contact between the conveying means (3a') and the substrate surface (4), whereas the conveying means (3a') is constructed as a conveyor roller positioned in such a way that it touches the transport plane (5), **characterized in that** the conveyor rollers (3a') have a varying diameter with at least two larger diameter areas (40') projecting over at least one smaller diameter area (41'), whereas the two larger diameter areas (40') are in each case provided on the sides of conveyor rollers (3a').

2. Device according to claim 1, **characterized in that** with the conveying means (3a') is associated a supply device (9) for supplying process medium (10) to an outer surface of the conveying means (3a').

3. Device according to claim 1 or 2, **characterized in that** the conveying means (3a') has a porous outer surface, which is in particular constructed for transporting process medium (10) from at least one delivery point provided in the conveying means (3a') to the outer surface of the conveying means (3a'), preferably by introducing pressurized process medium into the conveying means (3a).

4. Device according to claim 1, **characterized in that** the larger diameter areas (40') project approximately 1 to 10 mm, preferably 2 to 5 mm, over the at least one smaller diameter area (41').

5. Device according to claim 1 or 4, **characterized in that** the larger diameter areas (40') are at least 10 and preferably 12 to 30 mm wide.

6. System (35) with at least two devices (1') according to one of the preceding claims, **characterized in that** a first device (1') with a first transportation direction is provided and this is followed by a second device (1') with a second transportation direction, the substrates (2) passing from the first device to the second device, the first transportation direction being rotated by 90° relative to the second transportation direction.

7. System (35) with at least two devices (1') according to one of the claims 1 to 5, **characterized in that** downstream of a device (1') is provided a rotation station (37), which takes over the substrates (2) from the first device and transfers them to the second device, the substrates (2) being turned by 90° in transport plane (5) on the second device when compared with the first device.

8. System (35) according to claim 7, **characterized in that** the rotation station (37) itself rotates the substrates (2), particularly by 90° in transport plane (5), it being constructed for raising and rotating substrates (2) or rotation devices (38) are provided for this purpose.

9. System according to claim 7 or 8, **characterized in that** in juxtaposed manner the rotation station (37) has several individual rotation devices (38) and preferably the adjacent rotation devices (38) are in each case forwardly or rearwardly displaced in the transportation direction and in particular the rotation devices (38) are alternately arranged on two lines, which run perpendicular to the transportation direction and are spaced.

10. Method for wetting a substrate surface (4) of a substrate (2) with a device according to one of the preceding claims with a process medium (10) involving the steps:
- transporting the substrate (2) with transport means (3a') in a transport plane (5),
- wetting a downwardly directed substrate surface (4) at least substantially located in the transport plane (5) with a process medium (10), which is applied with a conveyor (3a') in direct mechanical contact to the substrate surface (4), whereas the application of the process medium (10) to the downwardly directed substrate surface takes place in the marginal area of the substrates (2), preferably in a 5 to 15 mm marginal area.

11. Method according to claim 10, **characterized by** a suction of process medium (10) in vapour or mist form before, during or after wetting the substrate surface (4) with suction means (11) arranged vertically below the transport plane (5), in order to prevent a deposition of process medium (10) on substrate surfaces other than the substrate surface (4) located in the transport plane (5).

12. Method according to claim 10 or 11, **characterized in that** the process medium (10) is applied to the sides of rectangular substrates (2) located to the left and right in the transportation direction and in particular using the conveyor rollers (3a') according to one of the claims 1 to 5.

13. Method according to claim 10 or 12, **characterized in that** the substrates (2) are firstly transported with a first orientation or alignment and the edges of the downwardly directed substrate surface are wetted with the process medium (10), followed by a rotation of the substrates by 90° in the transport plane and then a further wetting of the edges of the downwardly directed substrate surface on the two remaining lateral faces.

14. Method according to claim 13, **characterized in that** the rotation of the substrates (2) takes place outside devices (1') with the process medium (10), particularly at a rotation station (37) between the two devices (1') with the process medium (10).

15. Method according to claim 13 or 14, **characterized in that** the substrates (2) are transferred from a device (1') according to one of the claims 1 to 6 to a further such device (1'), the devices (1') having transportation directions at an angle of 90° to one another and the substrates (2) are transported on the devices (1') in in each case different transportation directions.

## Revendications

1. Dispositif (1') pour le traitement de la surface de substrats (2), avec des moyens de transport (3a') pour le transport d'un substrat (2) dans un plan de transport (5) déterminé par les moyens de transport (3a'), et avec au moins un moyen convoyeur (3a') qui est réalisé pour le mouillage du substrat (2) avec une substance de traitement (10) liquide, sachant que le moyen convoyeur (3a') est disposé au-dessous du plan de transport (5) de façon qu'il atteigne le plan de transport (5) ou qu'il atteigne presque le plan de transport (5) pour le mouillage avec la substance de traitement (10) de la surface (4) de substrat orientée vers le bas par un contact direct entre le moyen convoyeur (3a') et la surface de substrat (4), sachant que le moyen convoyeur (3a') est réalisé comme cylindre convoyeur, qui est disposé de manière à toucher le plan de transport (5), **caractérisé en ce que** les cylindres convoyeurs (3a') présentent un diamètre varié, avec au moins deux zones (40') présentant un diamètre plus grand qui saillent au-delà au moins d'une zone (41') présentant un diamètre plus petit, sachant que les deux zones (40') présentant le diamètre plus grand sont prévues respectivement des deux côtés du cylindre convoyeur (3a').

2. Dispositif d'après la revendication 1, **caractérisé en ce qu'**on associe au moyen convoyeur (3a') un dispositif d'amenée (9) pour l'amenée de la substance de traitement (10) à une surface extérieure du moyen convoyeur (3a').

3. Dispositif d'après la revendication 1 ou 2, **caractérisé en ce que** le moyen convoyeur (3a') présente une surface extérieure poreuse, qui est réalisée notamment pour le transport de la substance de traitement (10) à partir d'au moins un lieu de distribution prévu à l'intérieur du moyen convoyeur (3a') à la surface extérieure du moyen convoyeur (3a'), de préférence en envoyant de la substance de traitement sous pression dans le moyen convoyeur (3a).

4. Dispositif d'après la revendication 1, **caractérisé en ce que** les zones (40') présentant le diamètre plus grand dépassent la ou les zones (41') présentant le diamètre plus petit d'une valeur à peu près entre 1 mm et 10 mm, de préférence entre 2 mm et 5 mm.

5. Dispositif d'après la revendication 1 ou 4, **caractérisé en ce que** les zones (40') ayant le diamètre plus grand présentent une largeur au moins de 10 mm et de préférence entre 12 mm et 30 mm.

6. Installation (35) présentant au moins deux dispositifs (1') d'après une des revendications précédentes, **caractérisée en ce qu'**on prévoit un premier dispositif (1') avec une première direction de transport et ensuite un deuxième dispositif (1') avec une deuxième direction de transport, sachant que les substrats (2) passent du premier dispositif au deuxième dispositif, sachant que la première direction de transport est orientée à 90° par rapport à la deuxième direction de transport.

7. Installation (35) présentant au moins deux dispositifs (1') d'après une des revendications de 1 à 5, **caractérisée en ce qu'**à la suite d'un dispositif (1') on prévoit une station de rotation (37), qui prend en charge les substrats (2) en provenance du premier dispositif et les passe au deuxième dispositif, sachant que les substrats (2) dans le deuxième dispositif sont orientés à 90° dans le plan de transport (5) par rapport au premier dispositif.

8. Installation (35) d'après la revendication 7, **caractérisée en ce que** la station de rotation (37) tourne elle-même les substrats (2), notamment de 90° dans le plan de transport (5), sachant qu'elle est réalisée de manière à pouvoir soulever et tourner les substrats (2) ou encore qu'on prévoit des moyens de rotation (38) pour effectuer ces opérations.

9. Installation (35) d'après la revendication 7 ou 8, **caractérisée en ce que** la station de rotation (37) présente, l'un à côté de l'autre, plusieurs moyens de rotation (38) distincts, sachant que de préférence des moyens de rotation (38) limitrophes sont respectivement décalés les uns par rapport aux autres un peu en avant ou un peu en arrière en direction de transport et que notamment les moyens de transport (38) sont disposés alternativement sur deux lignes, qui s'étendent en direction orthogonale par rapport à la direction de transport et qui sont écartées l'une de l'autre.

10. Procédé de mouillage d'une surface (4) de substrat d'un substrat (2) avec une substance de traitement (10) avec un dispositif d'après une des revendications précédentes, présentant les pas suivants:
- Transport du substrat (2) par des moyens de transport (3a') dans un plan de transport (5),
- mouillage d'une surface (4) de substrat, disposée au moins essentiellement dans le plan de transport (5) et orientée vers le bas, avec une substance de traitement (10), qui est appliquée à la surface (4) de substrat au moyen d'un moyen convoyeur (3a') par un contact mécanique direct, sachant que l'application d'une substance de traitement (10) à la surface de substrat orientée vers le bas a lieu dans la zone marginale des substrats (2), de préférence dans une zone marginale comportant de 5 à 15 mm.

11. Procédé d'après la revendication 10, **caractérisé par** une aspiration de substance de traitement (10) évaporée ou nébulisée, avant, pendant ou après le mouillage de la surface (4) de substrat, par des moyens d'aspiration (11) disposés en direction verticale, au-dessous du plan de transport (5), pour éviter que de la substance de traitement (10) se dépose sur l'autre surface de substrat autre que la surface (4) de substrat qui est disposée dans le plan de transport (5).

12. Procédé d'après la revendication 10 ou 11, **caractérisé en ce que** la substance de traitement (10) est appliquée aux faces de substrats (2) rectangulaires situées à gauche et à droite vues en direction de transport, notamment par des cylindres convoyeurs (3a') d'après une des revendications de 1 à 5.

13. Procédé d'après la revendication 10 ou 12, **caractérisé en ce que** les substrats (2) sont d'abord transportés avec une première orientation ou encore disposition et qu'à cette occasion les bords de la surface de substrat montrant vers le bas sont mouillés avec la substance de traitement (10) et qu'ensuite a lieu une rotation des substrats (2) de 90° dans le plan de transport et qu'ensuite a lieu encore un mouillage des bords de la surface de substrat montrant vers le bas auprès des deux surfaces latérales restantes.

14. Procédé d'après la revendication 13, **caractérisé en ce que** la rotation des substrats (2) à lieu à l'extérieur des dispositifs (1') présentant la substance de traitement (10), notamment auprès d'une station de rotation (37) entre deux dispositifs (1') présentant de la substance de traitement (10).

15. Procédé d'après la revendication 13 ou 14, **caractérisé en ce que** les substrats (2) sont passés d'un dispositif (1') d'après une des revendications de 1 à 6 à un autre dispositif (1') de ce genre, sachant que les dispositifs (1') présentent des directions de transport orientées à 90° l'une par rapport à l'autre et que les substrats (2) dans le dispositifs (1') sont transportés respectivement dans des directions différentes.
